# EUROPEAN PATENT SPECIFICATION

(11) **EP 1 989 061 B1**
(45) Date of publication and mention of the grant of the patent: **07.09.2011**
(21) Application number: 07708424.2
(22) Date of filing: 20.02.2007
(51) Int. Cl.: B41C 1/10, G03F 7/11

(54) **METHOD FOR PRODUCING LITHOGRAPHIC PRINTING PLATE**
VERFAHREN ZUR HERSTELLUNG EINER LITHOGRAPHISCHEN DRUCKPLATTE
PROCEDE DE PRODUCTION DE PLAQUE LITHOGRAPHIQUE

(30) Priority: 01.03.2006 JP 2006055324
(43) Date of publication of application: 12.11.2008
(73) Proprietor: FUJIFILM Corporation, Minato-ku Tokyo 106-0031 (JP)
(72) Inventor: OSHIMA, Atsushi c/o Fujifilm Corporation, Haibara-gun, Shizuoka 4210396 (JP); MITSUMOTO, Tomoyoshi c/o Fujifilm Corporation, Haibara-gun, Shizuoka 4210396 (JP)
(74) Representative: Grünecker, Kinkeldey, Stockmair & Schwanhäusser Anwaltssozietät
(86) International application number: PCT/JP2007/053459
(87) International publication number: WO 2007/099887

(56) References cited:
- EP-A- 1 518 672
- JP-A- 11 065 101
- JP-A- 2002 052 854
- JP-A- 2004 086 231
- JP-A- 2005 037 510
- JP-A- 2006 267 959

## Description

### Technical Field

The present invention relates to a method for producing a lithographic printing plate, and particularly relates to a method for producing a lithographic printing plate suitable for applying a fine particle dispersion onto the surface of strip-shaped flexible support (hereinafter, referred to as "web") in the form of a sheet or web such as a thin metal plate, paper and a film to form a coating layer.

### Background Art

The lithographic printing plate is usually produced by forming a visible light exposure type or laser exposure type platemaking layer on a grained surface formed by subjecting at least one surface of an aluminum web which is an aluminum thin plate having a continues strip-shape to graining according to a conventional method.

This platemaking layer is composed of a photosensitive layer forming liquid containing a photosensitive resin or a thermosensitive layer forming liquid containing a thermally polymerizable resin. The platemaking layer is generally formed by applying a coating liquid for forming the platemaking layer having dispersed fine particles on the grained surface and drying the coating liquid.

Various kinds of coating techniques for such a coating liquid have been conventionally proposed (for example, see Japanese Patent Laid Open Nos. 2002-367158 and 2004-299264). Of these, Japanese Patent Laid Open No. 2002-367158 discloses a method for evaluating coating conditions using shearing energy in an extrusion type coating apparatus and determining the coating conditions by this evaluation result, thereby obtaining a good coating surface.

Japanese Patent Laid Open No. 2004-299264 discloses a method for controlling a pressure applied to a coating liquid when applying a photosensitive layer forming liquid containing a photosensitive resin at a predetermined value or less, and the method can prevent the condensation of polymer particles.

By the way, when applying the coating liquid having dispersed fine particles onto the web and drying the coating liquid, the following problems (the breakage of a fine particle dispersion) have occurred.
a) The fine particle dispersion contained in the coating liquid is broken when applying the coating liquid.
b) The fine particle dispersion is broken while transferring the web after drying the fine particle dispersion.
c) The fine particle dispersion is broken when taking up the web.
d) The fine particle dispersion is broken when cutting and laminating.

However, when the coating liquid containing such fine particles is applied onto the web and dried, and the web is transferred, only the liquid pressure of the coating liquid has been conventionally considered as shown in Japanese Patent Laid Open No. 2004-299264.

However, also in the step after drying, the fine particles are deformed and broken by the contact of the web and transfer roller and a transfer tension applied to the web to unfortunately cause degradation on the performance. When the fine particles are deformed and broken particularly in the lithographic printing plate, the developing property is deteriorated to cause dirt.

EP-A-1518672 and JP-A-2004/086231 disclose methods for producing lithographic printing plates which comprise the step of applying a coating liquid at atmospheric pressure to form a coating layer.

In view of the problems as described above, it is an object of the present invention to provide a method for producing a lithographic printing plate without any deterioration in plate making performance caused by deformation and breakage of fine particles.

### Disclosure of the Invention

The present invention provides a method for producing a lithographic printing plate, characterized by comprising the step of applying a coating layer liquid containing an inorganic compound as an overcoat on top of a photosensitive layer on a surface of a strip-shaped flexible web (14) at a pressure P applied to the coating liquid of more than 5 x10⁴ Pa and 1.5 × 10⁵ Pa or less, said pressure P being a liquid pressure of the space(s) surrounded by a head of a coating section (24) and the web (14) and filled with the coating liquid, said inorganic compound comprising particles having a thin flat plate shape having a particle diameter along the average major axis of from 0.3 to 20 µm and an average thickness of 0.1 µm or less, wherein said coating is effected on a running web at a line speed of 60 m/min or more, and the coating liquid is applied in an amount of 25 ml/m² or less .

Since the coating liquid is applied onto the surface of a web so that the pressure P applied to the coating liquid is set at more than 5×10⁴ Pa and 1.5 × 10³ Pa or less to form the coating layer, a lithographic printing plate without any deterioration in plate making performance caused by deformation and breakage of fine particles can be produced.

The inorganic compound dispersion is a liquid in which inorganic fine particles are dispersed. Examples of the inorganic fine particles include fine particles made of calcium carbonate, calcium sulfate, talc, clay, barium sulfate, barium carbonate, barium nitrate, kaolin, silica, alumina, white carbon, diatomaceous earth, alumina silicate, hectorite, aerosil, wollastonite, mica, bentonite, magnesium oxide, magnesium hydroxide, titania, iron black, iron oxide, iron chloride, carbon black, strontium carbonate, zinc white and zinc oxide.

The present invention further provides a method for producing a lithographic printing plate, characterized by comprising the step of applying a coating layer liquid containing an inorganic compound as an overcoat on top of a photosensitive layer on a surface of a strip-shaped flexible web (14) at a shearing stress τ applied to the coating liquid of 1.5 × 10⁵ Pa or less, said shearing stress τ being the shearing stress applied to a liquid in a space surrounded by a head of a coating section (24) and the web (14) and filled with the coating liquid, said inorganic compound comprising particles having a thin flat plate shape having a particle diameter along the average major axis of from 0.3 to 20 µm and an average thickness of 0.1 µm or less, wherein said coating is effected on a running web at a line speed of 60 m/min or more, the coating liquid is applied in an amount of 25 ml/m² or less, and the pressure P applied to the coating liquid is more than 5 × 10⁴ Pa, said pressure P being a liquid pressure of the space(s) surrounded by a head of a coating section (24) and the web (14) and filled with the coating liquid.

Since the coating liquid is applied onto the surface of the web so that the shearing stress τ applied to the coating liquid is set at 1.5 × 10³ Pa or less to form a coating layer, the lithographic printing plate without any deterioration in plate making performance caused by deformation and breakage of fine particles can be produced.

Moreover, the present invention provides a method for producing a lithographic printing plate, characterized by comprising the step of applying a coating layer liquid containing an inorganic compound as an overcoat on top of a photosensitive layer on a surface of a strip-shaped flexible web (14) at a sum total value P + τ of a pressure P and a shearing stress τ applied to the coating liquid of 1.5 × 10⁵ Pa or less, said pressure P being a liquid pressure of the space(s) surrounded by a head of a coating section (24) and the web (14) and filled with the coating liquid, said shearing stress τ being the shearing stress applied to a liquid in a space surrounded by a head of a coating section (24) and the web (14) and filled with the coating liquid, said inorganic compound comprising particles having a thin flat plate shape having a particle diameter along the average major axis of from 0.3 to 20 µm and an average thickness of 0.1 µm or less, wherein said coating is effected on a running web at a line speed of 60 m/min or more, the coating liquid is applied in an amount of 25 ml/m² or less, and the pressure P applied to the coating liquid is more than 5 x 10⁴ Pa.

Since the coating liquid is applied onto the surface of a web so that the sum total value P + τ of the pressure P and shearing stress τ applied to the coating liquid is set at 1.5 × 10⁵ Pa or less to form a coating layer, the lithographic printing plate without any deterioration in plate making performance caused by deformation and breakage of fine particles can be produced.

In the present invention, it is preferable that the method for producing the lithographic printing plate, further comprises the steps of: drying the coating layer; and winding the strip-shaped flexible support after drying the coating layer around a roller member so that a contact pressure Q applied to the strip-shaped flexible support is set at 1.5 × 10⁵ Pa or less and transferring the strip-shaped flexible support. Thus, the lithographic printing plate without any deterioration in plate making performance caused by deformation and breakage of fine particles can be further produced by controlling the contact pressure Q applied to the web at a predetermined value or less not only in application but also in transfer after drying.

In the present invention, it is preferable that the method for producing the lithographic printing plate, further comprises the steps of: drying the coating layer; and taking up the strip-shaped flexible support after drying the coating layer in a form of a roll so that a contact pressure Q applied to the strip-shaped flexible support is set at 1.5 × 10⁵ Pa or less. Thus, the lithographic printing plate without any deterioration in plate making performance caused by deformation and breakage of fine particles can be further produced by controlling the contact pressure Q applied to the web at a predetermined value or less not only in application but also in take-up in the form of a roll after drying.

In the present invention, it is preferable that the method for producing the lithographic printing plate, further comprises the steps of: drying the coating layer; and laminating the plurality of strip-shaped flexible supports after drying the coating layer so that a contact pressure Q applied to the strip-shaped flexible supports is set at 1.5 × 10⁵ Pa or less. Thus, the lithographic printing plate without any deterioration in plate making performance caused by deformation and breakage of fine particles can be further produced by controlling the contact pressure Q applied to the web at a predetermined value or less not only in application but also in cutting and laminating after drying.

As described above, according to the present invention, the lithographic printing plate without any deterioration in plate making performance caused by deformation and breakage of fine particles can be produced.

### Brief Description of the Drawings

Figure 1 illustrates an exemplary configuration of a production line to which a method for producing a lithographic printing plate of the present invention is applied;
Figure 2 is a perspective view of a laminate obtained by laminating lithographic printing original plates;
Figure 3 shows the results of Examples; and
Figure 4 shows the results of Examples.

### Description of the Symbols

10 ... production line, 12 ... feeder, 14 ... web, 16 ... surface-treatment section, 18 ... back coating and drying section, 20 ... base coating and drying section, 22 ... photosensitive layer coating and drying section, 24 ... overcoating and drying section

### Best Mode for Carrying Out the Invention

Hereinafter, preferred embodiments of the method for producing a lithographic printing plate of the present invention will be described in detail referring to the accompanying drawings.

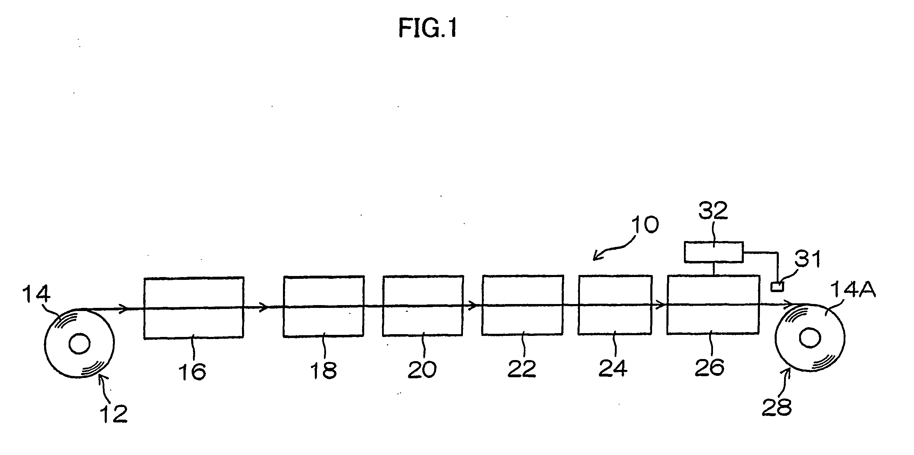

Figure 1 illustrates an example of a production line to which the method for producing a lithographic printing plate of the present invention is applied.

As shown in Figure 1, a rolled, long-sheet web 14 is set on a feeder 12. The web 14 continuously fed from the feeder 12 is surface-treated at a surface-treatment section 16. A back coat layer is formed on the back of the surface-treated web 14 at a back coating and drying section 18, and then at a base coating and drying section 20, a base coat layer is formed on the surface of the web 14.

Then, at a photosensitive layer coating and drying section 22, a photosensitive layer is formed on the base coat layer, and then at an overcoating and drying section 24, an overcoat layer is formed. Subsequently, the moisture content of the overcoat layer is controlled to a predetermined range at a humidity-controlled zone for overcoat layer 26. The moisture content of the overcoat layer is measured on line by an infrared content meter 31, and an air-conditioning unit 32 of the humidity-controlled zone for overcoat layer controls the temperature and humidity of the humidity-controlled zone for overcoat layer, so that the data of the moisture content is constant. Raw continuous sheet 14A of the lithographic printing plate is resulting, and taken up onto a take-up machine 28.

Although the raw continuous sheet 14A is taken up by the take-up machine 28 in the configuration shown in Figure 1, there can be also adopted an aspect in which after the raw continuous sheet 14A of the lithographic printing plate is produced, the raw continuous sheet 14A is cut into a predetermined size and the lithographic printing plates are laminated for every predetermined number of sheets.

Next, materials and processes which are important in the present invention will be described for every item.

### [Support (Web)]

For the web 14 used in the present invention, dimensionally stable aluminum or an alloy thereof (e.g. alloy with silicon, copper, manganese, magnesium, chromium, zinc, lead, bismuth or nickel) may be used. Generally, conventionally known materials listed in Aluminum Handbook 4th ed. (1990, published by Japan Light Metal Association) such as materials of JIS A 1050, JIS A 1100, JIS A3103, JIS A3004, JIS A3005 or an alloy obtained by adding 0.1 wt% or more of magnesium to these materials for improving tensile strength may be used.

Aluminum plates therefore may be produced by continuous casting-rolling in addition by conventional semi-continuous casting (DC method). For continuous casting-rolling, a twin-roll method, a belt caster method and a block caster method or the like may be used. The content of foreign element in the alloy is not more than 10% by weight. The thickness of the aluminum plate is preferably 0.1 mm to 0.6 mm.

In addition, a plastic film or paper to which aluminum or an aluminum alloy is laminated or deposited may also be used.

### [Surface Treatment of Support]

When the web 14 is an aluminum plate, the surface thereof is usually subjected to various surface treatments depending on purposes. In a general treatment method, the surface of the aluminum plate is first cleaned by degreasing or electropolishing and desmut treatment. The plate is then subjected to mechanical surface roughening treatment and/or electrochemical surface roughening treatment to create fine irregularities on the surface of the aluminum plate. At this stage, chemical etching treatment and desmut treatment may also be conducted. After that, anodizing treatment is conducted in order to increase the abrasion resistance of the surface of the aluminum plate, and the aluminum surface is then subjected to hydrophilizing treatment and/or sealing treatment according to need.

Between each treatment, draining by a nip roller and water washing using a spray or the like are preferably conducted in order to prevent the treating solution of the prior treatment from being introduced to the next treatment. Overflow waste liquid of the electrolytic solution used for the electrochemical surface roughening treatment may be used as a solution for desmut treatment, and in that case, the water washing after the desmut treatment may be omitted.

### (Degreasing and Electropolishing Treatment)

After removing rolling oil, natural oxide film and dirt on the aluminum plate, the aluminum plate is subjected to electropolishing treatment in an acidic aqueous solution or chemical etching treatment in an acidic or alkaline aqueous solution to conduct electrochemical surface roughening uniformly. The dissolved amount of the aluminum plate by the treatment is preferably 1 to 30 g/m², more preferably 1.5 to 20 g/m².

### (1) Electropolishing Treatment

Examples of electropolishing treatment for each material are described in a paper by Fujio Mamiya, "Surface Control", No. 21, pp 65 to 72, (1984).

Known aqueous solutions used for electropolishing can be used. An aqueous solution containing sulfuric acid or phosphoric acid as a main component is preferable, and an aqueous solution containing phosphoric acid as a main component is particularly preferable.

Conditions can be selected from a proportion of phosphoric acid of 20 to 90% by weight (preferably 40 to 80% by weight), a liquid temperature of 10 to 90°C (preferably 50 to 80°C), a current density of 1 to 100 A/dm² (preferably 5 to 80 A/dm²) and an electrolysis time of 1 to 180 seconds. 1 to 50% by weight of sulfuric acid, chromic acid, hydrogen peroxide, citric acid, hydrofluoric acid or phthalic anhydride may be added to the aqueous phosphoric acid solution.

Referring to current, direct current, pulse direct current or alternate current may be used, and continuous direct current is preferable. An electrolytic apparatus used here may be a known apparatus used for electrolytic treatment such as flat bath or radial bath. The solution may be directed in either a parallel flow or a counter flow relative to the aluminum plate, and the flow rate is selected from the range of 0.01 to 10000 cm/minute.

The distance between the aluminum plate and the electrode is preferably from 0.3 to 10 cm, particularly preferably 0.8 to 2 cm. For the feeding system, a direct feeding system using a conductor roll may be used or an indirect feeding system without a conductor roll (liquid feeding system) may be used. For the material and the structure of the electrode to be used, known materials and structures used for electrolytic treatment can be used, and the material of the cathode is preferably carbon and the material of the anode is preferably ferrite, iridium oxide or platinum.

### (2) Chemical Etching Treatment in Acidic or Alkaline Aqueous Solution

Details of chemical etching treatment of an aluminum plate in an acidic or alkaline aqueous solution are described in U.S. Pat. No. 3,834,398, and these known methods may be used. For acid or alkali that can be used for the acidic or alkaline aqueous solution, those described in Japanese Patent Laid Open No. 57-16918 may be used alone or in combination. It is preferable to conduct the treatment at a liquid temperature of 25 to 90°C for 1 to 120 seconds. The concentration of the acidic aqueous solution is preferably 0.5 to 25% by weight, and the proportion of aluminum dissolved in the acidic aqueous solution is preferably 0.5 to 5% by weight. The concentration of the alkaline aqueous solution is preferably 5 to 30% by weight, and the proportion of aluminum dissolved in the alkaline aqueous solution is preferably 1 to 30% by weight.

### (Desmut Treatment)

In the case of chemical etching using an aqueous solution containing a base, smut is generally formed on the surface of aluminum after the etching treatment, and therefore treatment (desmut treatment) is conducted using phosphoric acid, nitric acid, sulfuric acid, chromic acid or a mixed acid containing at least two of these.

The.acidic aqueous solution to be used may be one in which 0 to 5% by weight of aluminum is dissolved, and the treatment is conducted at a liquid temperature of room temperature to 70°C, and the time of treatment is preferably from 1 to 30 seconds. As the acidic aqueous solution, waste liquid of the electrolytic solution used for electrochemical surface roughening treatment may be used, but attention should be paid so as to avoid deposition of components in the desmut solution upon drying of the aluminum plate.

After the completion of the desmut treatment, draining by a nip roller and water washing using a spray are preferably conducted in order to prevent involvement of the treating solution in the next step, but the water washing may be omitted when the same aqueous solution is used in the next step.

### (Mechanical roughening treatment)

In order to obtain an excellent aluminum support, the surface of an aluminum plate is generally subjected to graining to create fine irregularities. As such graining, mechanical surface roughening treatment such as ball graining, brush graining, wire graining and blast graining are generally known, and brush graining is excellent for a large-scale, continuous treatment.

In the brush graining treatment, one or a plurality of brushes are generally used, and examples thereof include a method in which a plurality of one certain kind of brushes are used as described in Japanese Patent Publication No. 50-40047 and a method of using brushes of different materials, diameters or cross-sections as described in Japanese Patent Laid Open No. 6-135175. Specifically, a slurry of silica sand, aluminum hydroxide or the like is sprayed on the surface of an aluminum plate and a nylon brushing roll having a brush diameter of 0.2 to 0.9 mm is rotated at 50 to 500 rpm to conduct mechanical surface roughening treatment. Regarding the pushing strength of the brush, the power consumption of rotational driving motor (substantial electric power exclusive of mechanical loss of the driving motor) is preferably 0.2 to 15 kw, further preferably 0.5 to 10 kw.

### (Electrochemical Surface Roughening Treatment)

(1) Electrochemical surface roughening treatment using direct current is conducted in a hydrochloric acid- or nitric acid-based aqueous solution. This may be a solution used for usual electrochemical surface roughening treatment using alternate current. To prepare the solution, at least one of nitrate compounds such as aluminum nitrate, sodium nitrate and ammonium nitrate, or chloride compounds containing chloride ions is added to an aqueous 1 to 100 g/l hydrochloric acid or nitric acid solution at a proportion of 1 g/l to the saturation level.

Metal contained in an aluminum alloy such as iron, copper, manganese, titanium, magnesium or silica may be dissolved in the aqueous solution containing hydrochloric acid or nitric acid as a main component. It is preferable to use a solution obtained by adding aluminum chloride or aluminum nitrate to an aqueous solution containing 0.5 to 2% by weight of hydrochloric acid or nitric acid so that the proportion of aluminum ions is 3 to 50 g/l.

The temperature is preferably 10 to 60°C, more preferably 25 to 50°C. As an apparatus for electrochemical roughening using direct current, known apparatuses using direct current may be used, and an apparatus in which at least one pair of anode and cathode is alternately positioned as described in Japanese Patent Laid Open No. 1-141094 is preferably used.

Examples of known apparatus are described in Japanese Patent Laid Open No. 1-141094, Japanese Patent Laid Open No. 61-19115 and Japanese Patent Publication No. 57-44760. For direct current used for electrochemical roughening, it is preferred to use direct current having a ripple rate of not more than 20%. The current density is preferably 10 to 200 A/dm², and when the aluminum plate is on the anode, the quantity of electricity is preferably 10 to 1000 C/dm³.

The anode may be selected for use from known oxygen generating electrodes such as ferrite, iridium oxide, platinum and those obtained by cladding or plating platinum on valve metal such as titanium, niobium or zirconium. The cathode may be selected for use from carbon, platinum, titanium, niobium, zirconium, stainless steel and cathodes for fuel cells.

(2) Electrochemical surface roughening treatment using alternate current is conducted in a hydrochloric acid- or nitric acid-based aqueous solution. This may be a solution used for usual electrochemical surface roughening treatment using alternate current. To prepare the solution, at least one of nitrate compounds containing nitrate ions such as aluminum nitrate, sodium nitrate and ammonium nitrate and chloride compounds containing chloride ions such as aluminum chloride, sodium chloride and ammonium chloride can be added to an aqueous 1 to 100 g/l hydrochloric acid or nitric acid solution in a proportion of 1 g/l to the saturation level.

Metal contained in an aluminum alloy such as iron, copper, manganese, nickel, titanium, magnesium or silica may be dissolved in the aqueous solution containing hydrochloric acid or nitric acid as a main component. It is preferable to use a solution obtained by adding aluminum chloride or aluminum nitrate to an aqueous solution containing 0.5 to 2% by weight of hydrochloric acid or nitric acid so that the proportion of aluminum ions is 3 to 50 g/l. The temperature is preferably 10 to 60°C, more preferably 25 to 50°C.

(3) The waveform of the alternating current from a power source used for electrochemical roughening treatment may be sinusoidal, square, trapezoidal or triangular, preferably square or trapezoidal, particularly preferably trapezoidal. The time (TP) for the current to reach a peak from zero is preferably from 1 to 3 msec. When the time is less than 1 msec, irregularity called chatter mark, which is formed in the direction perpendicular to the traveling direction of the aluminum plate, tends to be easily formed. When the TP is more than 3 msec, trace components such as ammonium ion, which spontaneously increase by electrolysis treatment of nitric acid in the electrolytic solution used for the electrochemical roughening, influence the surface roughening more, making uniform graining more difficult.

(4) Trapezoidal alternate current having a duty ratio of 1:2 to 2:1 may be used, and as described in Japanese Patent Laid Open No. 5-19300, one having a duty ratio of 1:1 is preferable in the case of indirect feeding system in which no conductor roll is used for aluminum. Trapezoidal alternate current having a frequency of 0.1 to 120 Hz may be used, and 50 to 70 Hz is preferable in view of facilities. When the frequency is less than 50 Hz, the carbon electrode which is the main electrode tends to be dissolved easily. When it is more than 70 Hz, influence of inductance components on the power supply circuit tends to increase, causing high cost of power supply. In this regard, when using an aluminum alloy containing more than 0.1 wt% of Cu, alternate current having a frequency of 0.1 to 10 Hz is preferably used. The current density is preferably 10 to 200 A/dm² at the peak of the current wave.

(5) As an electrolytic bath used in the electrochemical surface roughening treatment, known electrolytic bathes used for surface treatment such as vertical, flat or radial bath may be used, and a radial electrolytic bath described in Japanese Patent Laid Open No. 5-195300 is particularly preferable. The electrolytic solution which passes through the electrolytic bath may be in either a parallel flow or counter flow to the traveling direction of the aluminum web.

(6) One or more AC power supplies may be connected to the electrolytic bath. It is preferable that while controlling the current ratio between the anode and the cathode of alternate current applied to the aluminum plate opposed to the main electrode, an auxiliary anode for preventing dissolution of the main carbon electrode is provided to shunt a part of the alternate current. By shunting part of the current as direct-current to the auxiliary anode provided in a bath different from the bath in which the two main electrodes are provided via a rectifying device or a switching device, the ratio of the current value for the anodizing reaction to the current value for the cathodic reaction, which current is exerted on the aluminum plate opposed to the main electrode, can be controlled. The ratio of the quantities of electricity (quantity of electricity at cathode/quantity of electricity at anode) for the anodizing reaction and the cathodic reaction on the aluminum plate opposed to the main electrode is preferably 0.3 to 0.95.

(7) Japanese Patent Laid Open No. 6-135175 describes that the waveform of alternate current used in the electrochemical roughening step is sinusoidal, trapezoidal or square. Japanese Patent Laid Open No. 5-195300 describes use of a radial electrolytic bath in the electrochemical roughening treatment and provision of an auxiliary anode in the same bath in which the main electrode is placed. In addition, Japanese Patent Publication No. 6-37716 describes shunting of part of current as direct current to an auxiliary anode provided separately from the two main electrodes.

(8) When electrochemical surface roughening treatment of the aluminum plate is conducted in an aqueous solution containing nitric acid or hydrochloric acid as a main component using alternate current or direct current with a quantity of electricity of 10 to 1000 C/dm², the time for the current to reach a peak from zero ranging from 1 to 3 msec and a trapezoidal alternate current having a frequency of 50 to 70 Hz are used in this acidic aqueous solution.

### (Chemical Etching Treatment (In Acidic or Alkaline Solution))

Chemical etching treatment is conducted for smoothing fine grained irregularities created by mechanical surface roughening treatment or electrochemical surface roughening treatment, or for removing smut and the like. Details of the etching method are described in U.S. Pat. No. 3,834,398, and these known methods may be used. For acid or alkali that can be used for the acidic or alkaline aqueous solution, those described in Japanese Patent Laid Open No. 57-16918 may be used alone or in combination. It is preferable to conduct the treatment at a liquid temperature of 25 to 90°C for 1 to 120 seconds. The concentration of the acidic aqueous solution is preferably 0.5 to 25% by weight, and the proportion of aluminum dissolved in the acidic aqueous solution is preferably 0.5 to 5% by weight. The concentration of the alkaline aqueous solution is preferably 5 to 30% by weight, and the proportion of aluminum dissolved in the alkaline aqueous solution is preferably 1 to 30% by weight.

The etching treatment is conducted so that the amount of the aluminum plate dissolved in the acidic or alkaline aqueous solution is not less than 1 g/m² to not more than 30 g/m² (E treatment: etching after mechanical surface roughening treatment) or the amount of aluminum dissolved therein is not less than 0.1 g/m² to not more than 3 g/m² (F treatment: electrochemical roughening treatment).

In the case of chemical etching using an aqueous solution containing a base, smut is generally formed on the surface of aluminum. In that case, etching treatment (required desmut treatment) is conducted using phosphoric acid, nitric acid, sulfuric acid, chromic acid or a mixed acid containing at least two of these (as in the desmut treatment described above).

### (Anodizing Treatment)

In order to increase the water retention property and the abrasion resistance of the surface of the aluminum plate, anodizing treatment is conducted. Any electrolyte may be used for the anodizing treatment of the aluminum plate as long as it can form a porous oxide film. Generally, sulfuric acid, phosphoric acid, oxalic acid, chromic acid or a mixed solution thereof is used. The concentration of these electrolytes is determined depending on the kind of the electrolyte. The conditions of the anodizing treatment cannot be simply determined as they are different depending on the kind of electrolyte, but generally a concentration of the electrolyte of 1 to 80 wt%, a liquid temperature of 5 to 70°C, a current density of 1 to 60 A/dm², a voltage of 1 to 100 V, and an electrolysis time of 5 seconds to 300 seconds are appropriate.

Sulfuric acid methods are generally conducted using a direct current, but alternate current may also be used. The amount of anodized film is preferably in the range of 0.5 to 10 g/m². Sulfuric acid is used at a concentration of 5 to 30%, and the electrolytic treatment is conducted at a temperature range of 20 to 60°C for 5 to 250 seconds. It is preferable that the electrolytic solution contains aluminum ions. The current density in this case is preferably 1 to 50 A/dm². In the case of a phosphoric acid method, treatment is conducted at a concentration of 5 to 50%, a temperature of 30 to 60°C and at a current density of 1 to 15 A/dm² for 10 to 300 seconds. The amount of anodized film is preferably not less than 1.0 g/m², more preferably 2.0 to 6.0 g/m².

### (Hydrophilizing Treatment)

After conducting the anodizing treatment, the surface of the aluminum is subjected to hydrophilizing treatment according to need. Examples of the hydrophilizing treatment to be employed in the present invention include a method using alkali metal silicate (e.g. an aqueous sodium silicate solution) as disclosed in U.S. Pat. Nos. 2,714,066, 3,181,461, 3,280,734 and 3,902,734. In these methods, the web is immersed or subjected to electrolysis in the aqueous sodium silicate solution. It is also possible to employ a method involving treatment with potassium fluorozirconate as disclosed in Japanese Patent Publication No. 36-22063, or a method involving treatment with polyvinylphosphonic acid as disclosed in U.S. Pat. Nos. 3,276,868, 4,153,461 and 4,689,272.

### (Other Treatment (Water-Washing, Sealing))

After the completion of each treatment, draining by a nip roller and water washing using a spray are conducted in order to prevent mixing of the treating solution to the next step. It is also preferable to conduct sealing treatment after the anodizing treatment. Such sealing treatment is conducted by immersion into hot water and hot aqueous solution containing an inorganic salt or an organic salt, and in a steam dryer.

### (Coating Method)

To coat a coating liquid, a method using a coating rod described in Japanese Patent Publication No. 58-4589 and Japanese Patent Laid Open No. 59-133568, a method using an extrusion coater described in Japanese Patent Laid Open No. 4-244265, or a method using a slide bead coater described in Japanese Patent Publication No. 1-57629 and Japanese Patent Laid Open No. 10-128212 may be used, but the method is not limited to these. In addition, for example, a curtain coating method, a roll coating method and a gravure coating method or the like can be used. In the following, some of the methods will be described in detail, and then coating conditions will be described.

### (1) Rod Coating Method

The method using a coating rod comprises allowing a coating rod to contact with the running web 14 to coat a predetermined amount thereon. The method using a coating rod includes a technique in which one coating rod has both functions of transferring the coating solution to apply it to the web 14 and adjusting the amount of the coating solution, and a technique in which the coating solution previously excessively applied to the web 14 is wiped by a coating rod to adjust the amount of the coating solution. The former is a method in which the coating solution is supplied so as to form a liquid pool immediately before the contact section of the coating rod and the web 14, and the coating amount is adjusted using the coating rod to obtain a desired coating amount.

In these methods using a coating rod, the coating rod may be in a stationary state or rotated in the direction the same as or opposite from that of the web 14 at any peripheral speed. In that case, the coating rod may be rotated compulsorily according to a method such as using an external driving device, or rotated following the running web 14 upon contact therewith.

The wrapping angle of the web 14 with respect to the coating rod may be set to the range of preferably 1 degree to 30 degrees, more preferably 2 degrees to 20 degrees.

Regarding the properties of the coating solution, the viscosity is not more than 100 cp, more preferably not more than 50 cp, and the surface tension is preferably in the range of 20 to 70 dyne/cm.

In this method, the coating amount is controlled by the size of the groove made on the surface of the coating rod, or if a wire rod with wire wound around a rod is used, the coating amount is controlled by the size of the wire. While the range to which the coating amount is controlled is not particularly limited, a range of 3 to 100 cc/m² is usually employed. The diameter of the coating rod is not particularly limited, but is 6 to 25 mm, preferably 6 to 15 mm. As a material of the rod, metal is preferable in view of the corrosion resistance and the strength, and stainless steel is particularly preferable.

As a coating rod used in the present invention, for example, a wire rod around which wire is thickly taken up in the circumferential direction of the rod surface thereby forming grooves between wires, and a grooved rod having grooves engraved for the full length or at necessary portions of the rod surface in the circumferential direction are used.

When a wire rod is used, an appropriate wire diameter is 0.07 to 1.0 mm, preferably 0.07 to 0.6 mm. Metal is used as a material of wire, and in view of the corrosion resistance, abrasion resistance and strength, stainless steel is most preferable. Plating may be conducted on the surface of the wire rod for further improving the abrasion resistance, and hard chrome plating is particularly preferable.

When a grooved rod is used in the present invention, the pitch of the groove is 0.05 to 1.0 mm, preferably 0.1 to 0.6 mm, and the cross section is suitably substantially sinusoidal or trapezoidal. However, the cross-sectional shape is not limited to these and those with a different cross-sectional shape can also be used. Plating may be conducted on the surface of the grooved rod as well for further improving the abrasion resistance, and hard chrome plating is particularly preferable.

In view of the high speed rotation of the rod, a material having a low friction resistance with respect to the rod (wire in the case of a wire rod) must be selected as a material of a rod supporting member. Examples of the material of the rod supporting member and the barrier member include fluorine resins, polyacetal resins, polyethylene resins and the like. Of these, polytetrafluoroethylene known as Teflon (registered trade name, DuPont, USA) and polyacetal resin known as Derlin (registered trade name, DuPont, USA) are particularly preferable from the viewpoint of the friction coefficient and the strength. In addition, those obtained by adding a filler such as glass fiber, graphite and molybdenum disulfide to these plastic materials can also be used. Further, after producing the rod supporting member using a metal material, the above-mentioned plastic materials may be coated on or attached to the surface to decrease the friction coefficient with respect to the bar. Alternatively, various kinds of metal materials impregnated with the above-mentioned plastic materials, e.g. aluminum impregnated with polytetrafluoroethylene, can also be used for the rod supporting member.

### (2) Extrusion Coating Method

As another method, a method of coating comprising discharging a coating solution from an extrusion injector, winding it on a backup roller to form coating bead in the space between the injector and the running web 14, and depressurizing the rear portion of the coating bead or pressurizing the front portion thereof can be used. In this method, about 10 to 500 cc/m² of the coating solution may be coated, although it depends on the clearance between the web 14 and the tip of the injector. For the properties of the coating solution, the viscosity is preferably in the range of 0.7 to 100 cp, and the surface tension is preferably in the range of 20 to 50 dyne/cm. The clearance between the web 14 and the injector is generally 0.1 to 0.5 mm.

### (3) Slide Coating Method

As yet another method, a method of coating comprising forming coating bead through a spacing across which a liquid film of the coating solution dripping down the slide face meets the running web 14 at the edge of the slide face, thereby coating the coating solution on the web 14 through this bead can be used. Where necessary, the rear portion of the bead may be depressurized or the front portion thereof may be pressurized to coat. In this method, about 10 to 100 cc/m² of the coating solution may be applied. For the properties of the coating solution, the viscosity is preferably in the range of 1 to 200 cp, and the surface tension is preferably in the range of 20 to 60 dyne/cm. The clearance between the web 14 and the injector is generally 0.1 to 0.6 mm.

### (4) Coating Conditions

It is important to satisfy the following conditions (a) to (c) in applying the coating liquid onto the surface of the web 14.

### (a) Pressure P Applied to Coating Liquid

The coating liquid is applied onto the surface of the web 14 so that the pressure P applied to the coating liquid is set at more than 5×10⁴ Pa and 1.5 × 10³ Pa or less to form a coating layer. This pressure P means a liquid pressure of the space surrounded by a head of a coating section and the web 14 and filled with the coating liquid.

For example, when T is set as a tension applied to the web 14 and R is set as a radius of the rod in the case of the rod coating method of the item (1), the pressure P can be represented by the formula of P = 2T/πR.

### (b) Shearing Stress τ Applied to Coating Liquid

The coating liquid is applied onto the surface of the web 14 so that the shearing stress τ applied to the coating liquid is set at 1.5 × 10⁵ Pa or less to form a coating layer. This shearing stress τ means a shearing stress applied to a liquid in a space surrounded by the head of the coating section and the web 14 and filled with the coating liquid.

For example, when the viscosity of the coating liquid is set as µ, and the shearing speed of the coating liquid is set as γ, the shearing stress τ can be represented by the formula of τ =µγ.

### (c) Sum Total Value P + τ of Pressure P and Shearing Stress τ Applied to Coating Liquid

The coating liquid is applied to the surface of the web 14 so that the sum total value P + τ of the pressure P and shearing stress τ applied to the coating liquid is set at 1.5 × 10⁵ Pa or less to form a coating layer.

As specific methods for satisfying the conditions (a) to (c), the conditions (a) to (c) can be attained by reducing the tension of the web 14 in transferring the web 14, reducing the viscosity of the liquid, or reducing the transferring speed of the web 14.

When the pressure P (liquid pressure) is too low, high-speed thin layer coating aptitude is lost. The high-speed thin layer coating aptitude means that a line speed is 60 m/min or more and the coating liquid is applied in the amount of 25 ml/m¹ or less. For this purpose, P > 5 x 10⁴ Pa is required.

Furthermore, in contact coating methods such as a bar coating method, a roll coating method and a gravure coating method, the pressure P (liquid pressure) can be attained by enlarging the diameter of a bar (a roller and a gravure roller) and by increasing the rotation of the bar (the roller and the gravure roller) in the traveling direction of the web 14 in addition to the methods described above.

In a transferring step after coating and drying the dispersion liquid, a pressure (planar pressure) Q applied to the surface onto which the dispersion liquid is applied may be set to Q ≤ 1.5 × 10⁵ Pa. As this specific method, the pressure Q is attained by enlarging the diameter of the roller or reducing the tension in the roller transfer. Also, a non-contact transferring method may be used.

Also, when the take-up step after coating and drying is performed, a pressure (planar pressure) Q applied to the dispersion liquid coating surface in the take-up section may be set to Q ≤ 1.5 × 10⁵ Pa. As this specific method, the pressure Q is attained by reducing the tension in take-up or enlarging the core diameter in take-up.

Furthermore, when the web 14 is cut, and the cut webs 14 are then accumulated in a flat plate form (hereinafter, referred to as "flat plate") and stored, a pressure (planar pressure) Q applied to the flat plate of the undermost layer may be set to Q ≤ 1.5 × 10⁵ Pa. As this specific method, the pressure Q is attained by reducing the number of the plates to be accumulated or by laminating the plates while inclining.

### [Formation of Back Coat Layer]

At a back coating and drying section 18, a coating layer (hereinafter referred to as back coat layer) composed of an organic polymer compound is formed on the back of the web 14 according to need for preventing scuffing of the composition layer when superposed.

As a main component of the back coat layer, at least one resin having a glass transition temperature of not less than 20°C selected from the group consisting of saturated copolymerized polyester resin, phenoxy resin, polyvinyl acetal resin and vinylidene chloride copolymerized resin may be used. The saturated copolymerized polyester resin comprises dicarboxylic acid units and diol units.

Examples of the dicarboxylic acid unit of the polyester include: aromatic dicarboxylic acids such as phthalic acid, terephthalic acid, isophthalic acid, tetrabromophthalic acid and tetrachlorophthalic acid; and saturated aliphatic dicarboxylic acids such as adipic acid, azelaic acid, succinic acid, oxalic acid, suberic acid, sebacic acid, malonic acid and 1,4-cyclohexanedicarboxylic acid.

Further, the back coat layer may optionally include a dye or a pigment for coloring, a silane coupling agent, diazo resin composed of a diazonium salt, organic phosphonic acid, organic phosphoric acid and a cationic polymer for improving adhesion to the aluminum support, and wax, higher fatty acid, higher fatty acid amide, a silicone compound comprising dimethylpolysiloxane, modified dimethylsiloxane and polyethylene powder which are usually used as a lubricant.

Basically, the back coat layer may have a thickness that can prevent the composition layer from scuffing even in the absence of a slip sheet, and the thickness is preferably 0.01 to 8 µm. Various methods may be used to form the back coat layer on the back of the web 14, and examples thereof include a method in which a solution or emulsified dispersion is prepared using a suitable solvent and the solution or dispersion is applied and dried; a method in which a film formed in advance is laminated on the web 14 using an adhesive or heat; and a method in which a molten film is formed by a melt extruder and then the film is laminated on the web 14. Most preferred for achieving the aforementioned coating amount is the method of forming a solution and applying and drying the same.

### [Formation of Base Coat Layer]

At the base coating and drying section 20, a base coat layer coating solution is applied to the surface of the web 14 where necessary and the solution is dried to form a base coat layer. As the methods and conditions of application in the base coating and drying section 20, many of those used for applying a composition layer described above may be used. That is, a method using a coating rod, a method using an extrusion coater and a method using a slide bead coater may be used.

### [Formation of Photosensitive Layer]

At the photosensitive layer coating and drying section 22, a coating of photopolymerizable photosensitive composition is applied to the base coat layer and dried to form a photosensitive layer.

Organic solvents described in Japanese Patent Laid Open Nos. 62-251739 and 6-242597 may be used as a solvent for dissolving the photopolymerizable photosensitive composition. The photopolymerizable photosensitive composition is dissolved and dispersed at a solid concentration of 2 to 50% by weight and applied to the web 14 and dried.

The amount of photopolymerizable photosensitive composition layer (photosensitive layer) to be applied on the web 14 is different depending on the purpose of use, and is generally preferably 0.3 to 4.0 g/m² based on the weight after drying. The smaller the amount to be applied, the smaller the amount of exposure for forming an image, but the film strength is reduced. On the other hand, the larger the amount to be applied, the stronger the photosensitive film although the amount of exposure required is increased. For example, when used as a printing plate, a printing plate capable of printing a great number of copies (high plate durability) can be obtained. The photosensitive composition may contain a surfactant, particularly preferably a fluorinated surfactant, to improve the property of the coated surface.

The photopolymerizable photosensitive composition constituting the photosensitive layer of the photosensitive lithographic printing plate used in the present invention contains, as essential components, an ethylenically unsaturated compound which can be polymerized by addition polymerization, a photopolymeric initiator and a polymer binder, and where necessary, various compounds such as a colorant, a plasticizer and a thermal polymerization inhibitor may be used together.

The photopolymeric initiator (system) is generally used in an amount of 0.05 to 100 parts by weight, preferably from 0.1 to 70 parts by weight, more preferably from 0.2 to 50 parts by weight, based on 100 parts by weight of the ethylenically unsaturated bond-containing compound.

As the polymer binder used for the photosensitive layer of the photosensitive lithographic printing plate according to the present invention, organic high molecular weight polymers which are soluble or swellable in alkaline water are used, because they should not only serve as a film-forming agent of the compound but also be dissolved in alkaline developer.

Upon coating the photosensitive composition on the web 14, the composition is used after dissolving in various types of organic solvents. Examples of the solvent used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylfomamide, dimethyl sulfoxide, γ-butyrolactone, methyl lactate and ethyl lactate. These solvents may be used alone or in a mixture. The concentration of solids in the coating solution is preferably 1 to 50% by weight.

### [Formation of Overcoat Layer]

An inorganic layer compound contained in the overcoat layer in a original plate of the lithographic printing plate contains particles having a thin flat plate shape, and examples thereof include a mica group such as natural mica and synthetic mica represented by the following general formula A(B,C)₂₋₅D₄O₁₀(OH,F,O)₂, talc represented by the formula 3MgO·4SiO·H₂O, taeniolite, montmorillonite, saponite, hectorite and zirconium phosphate, wherein A is any of K, Na and Ca; B and C are any of Fe (II), Fe (III), Mn, Al, Mg and V; and D is Si or Al.

In the mica group, examples of the natural micas include white mica, soda mica, phlogopite, black mica and lepidolite. Also, examples of synthetic micas include unswelling mica such as fluoric phlogopite KMg₃ (AlSi₃O₁₀)F₂ and potassium tetrasilicon mica KMg_{2.5}(Si₄O₁₀)F₂, and swelling mica such as Na tetrasilyric mica NaMg₂.₅(Si₄O₁₀)F₂, Na, or Li taeniolite(Na,Li)Mg₂Li(Si₄O₁₀)F₂, montmorillonite Na or Li hectorlite(Na, Li) _{1/S}Mg_{2/5}Li_{1/8} (Si₄O₁₀)F₂. In addition, synthetic smectite is also useful.

Of the inorganic layer compounds, the fluoric swelling mica which is a synthetic inorganic layer compound is particularly useful. That is, swelling clay minerals such as the swelling synthetic mica and the montmorillonite, the saponite, the hectorite and the bentonite have a laminated structure composed of a unit crystalline lattice layer having a thickness of about 1.0 to 1.5 nm, and the metal atom substitution in a lattice is remarkably larger than those of the other clay minerals. As a result, the lattice layer produces the shortage of positive charges, and adsorbs positive ions such as Na⁺, Ca²⁺ and Mg²⁺ between the layers in order to compensate the shortage.

The positive ions mediating between these layers are referred to as exchangeable positive ions, and are exchanged with various positive ions. When the positive ions between the layers are particularly Li⁺ and Na⁺, the ion radius is small, and a binding between layer crystal lattices is weak. Thereby the swelling clay minerals are largely swelled by water. When they are sheared in such a state, the swelling clay minerals are easily cleaved to form sol stabilized in water. The bentonite and the swelling synthetic mica have this strong tendency, and are useful. Particularly, the swelling synthetic mica is preferably used.

As the shape of the inorganic layer compounds to be used, from a viewpoint of diffusion control, the thickness thereof is preferably smaller, and the plane size is preferably larger as long as the smoothness of the coating surface and the transmission of an actinic ray are not lowered. Therefore, the aspect ratio is 20 or more, preferably 100 or more, and particularly preferably 200 or more. The aspect ratio is a ratio of a thickness to the major axis of a particle, and for example, can be measured from a projection view due to the microphotograph of the particle. The larger the aspect ratio is, the larger the obtained effect is.

Referring to the particle diameter of the inorganic layer compound to be used, the average major axis is 0.3 to 20 µm, preferably 0.5 to 10 µm, and particularly preferably 1 to 5 µm. The average thickness of the particles is 0.1 µm or less, preferably 0.05 µm or less, and particularly preferably 0.01 µm or less. For example, referring to size of the swelling synthetic mica which is a typical compound of the inorganic layer compounds, the thickness is 1-50 nm and the surface size is 1 to 20 µm.

Thus, when the particles of the inorganic layer compound having a large aspect ratio are contained in the overcoat layer, the strength of the film is enhanced, and the penetration of oxygen or moisture can be effectively prevented. Thereby, the degradation of the overcoat layer due to deformation or the like is prevented, and even when the particles are stored under a high humidity condition for a long period of time, the particles have excellent preservation stability without reducing image forming property in the original plate of the lithographic printing plate due to the change of humidity.

The content of the inorganic layer compound in the overcoat layer is preferably 5/1 to 1/100 in a mass ratio to the amount of the binder used for the overcoat layer. Even when a plurality of kinds of inorganic layer compounds are used together, it is preferable that the sum total amount of these inorganic layer compounds is the above-described mass ratio.

Light exposure is usually conducted in the atmosphere. The overcoat layer prevents the penetration of low molecular compounds, such as oxygen and a basic substance, into the image recording layer, which inhibit an image forming reaction caused by the exposure in the image recording layer and exist in the atmosphere, and prevents the inhibition of the image forming reaction due to the exposure in the atmosphere. Therefore, referring to the characteristic desired for the overcoat layer, the permeability of a low molecular compound such as oxygen should be low. Furthermore, one having good permeability of light used for the exposure, excellent adhesion with the image recording layer, and capable of being easily removed in the developing process step on a machine after the exposure is preferable. The overcoat layer having such a characteristic has been variously examined. For example, the overcoat layer is disclosed in U.S. Pat. No. 3458311 and Japanese Patent Publication No. 55-49729 in detail.

It is preferable to use a binder together with the inorganic layer compound for the overcoat layer. The binder is not particularly limited as long as the inorganic layer compound can be well dispersed and an uniform film adhered to the image recording layer can be formed, and either a water-soluble polymer or a water-insoluble polymer may be used if it is suitably selected.

Specific examples thereof include polyvinyl alcohol, modified polyvinyl alcohol, polyvinyl pyrrolidone, polyvinyl imidazole, polyacrylic acid, poly acryl amide, a partial saponified material of polyvinyl acetate, an ethylene-vinyl alcohol copolymer, a water-soluble cellulose derivative, gelatin, a starch derivative, a water-soluble polymer such as gum arabic, and polymers such as polyvinylidene chloride, poly(meta)acrylonitrile, polysulfone, polyvinyl chloride, polyethylene, polycarbonate, polystyrene, polyamide and cellophane. Two or more kinds thereof can be also used together if needed.

Of these, from a viewpoint of the easiness of removal of a protection layer which remains in a non-image area and the handling ability in forming a film, the water-soluble polymer is preferable. The polyvinyl alcohol, the polyvinyl pyrrolidone, the polyvinyl imidazole, the water-soluble acrylic resins such as the polyacrylic acid, the gelatin and the gum arabic or the like are preferable. Of these, the polyvinyl alcohol, polyvinyl pyrrolidone, gelatin and gum arabic or the like capable of applying water as the solvent and being easily removed by wetting water in printing are more preferable.

As long as the polyvinyl alcohol which can be used for the overcoat layer contains unsubstituted vinyl alcohol units in a substantial amount sufficient for imparting required water solubility, the polyvinyl alcohol may be partially substituted by ester, ether or acetal. Similarly, the polyvinyl alcohol may contain the other copolymerizing components partially. Such polyvinyl alcohol includes those hydrolyzed to an extent of 71 to 100 mol% and having a polymerization degree of 300 to 2400.

Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 which are available from KURARAY CO., LTD.

Examples of the copolymer include polyvinyl acetate chloroacetate or propionate, polyvinyl formal, polyvinyl acetal and copolymers thereof, which are hydrolyzed to an extent of 88 to 100 mol%.

Next, the example of the general dispersion method for the inorganic layer compound used for the overcoat layer will be described. First, 5 to 10 parts by mass of the swelling layer compound previously mentioned as the preferable inorganic layer compound is added to 100 parts by mass of water, and is sufficiently familiarized with water. After the layer compound is swelled, the layer compound is dispersed in a dispersion machine. Examples of the dispersion machines used herein include various mills for applying force mechanically and directly to disperse, a high-speed stirring dispersion machine having a large shearing force and a dispersion machine for applying high-intensity ultrasonic energy.

Specific examples include a ball mill, a sand grinder mill, a visco mill, a colloid mill, a homogenizer, a dissolver, a polytron, a homomixer, a homoblender, a keddy mill, a jetagitor, a capillary tube type emulsification, a fluid siren, an electromagnetic distortion type ultrasonic wave generator, and an emulsification having a poleman whistle.

The dispersion of 5 to 10% by mass of the inorganic layer compound dispersed by the above-mentioned method has high viscosity or is a gel, and has very good preservation stability. When the overcoat layer coating liquid is prepared using this dispersion, it is preferable that after the dispersion is diluted with water and is sufficiently stirred, the dispersion is blended with a binder solution and to prepare the overcoat layer coating liquid.

Known additives such as a surfactant for improving the coatability and a water-soluble plasticizer for improving properties of the film may be added to the coating liquid for the overcoat layer. Examples of the water-soluble plasticizer include propionamide, cyclohexane diol, glycerin and sorbitol. In addition, water-soluble (meth)acrylic polymer may also be added. Furthermore, known additives for enhancing the adhesion with the image recording layer and the temporal stability of the coating liquid may be added to this coating liquid.

The overcoat layer coating liquid thus prepared is applied on the image recording layer provided on the web, and dried to form an overcoat layer. Although the coating solvent can be suitably selected in relation with the binder, it is preferable to use distilled water and refining water when using the water-soluble polymer.

The coating amount of the overcoat layer is preferably 0.01 g/m² to 10 g/m² in the coating amount after drying, more preferably 0.02 g/m² to 3 g/m², and most preferably 0.02 g/m² to 1 g/m².

### (Drying Method)

Examples of the drying method include a method in which a pass roll is placed in a dryer and the web 14 is wrapped on the pass roll and transferred to conduct drying with spraying hot air thereto as described in Japanese Patent Laid Open No. 6-63487, a method in which air is supplied from the top face and the bottom face of the web 14 through a nozzle to dry the web 14 while it is lifted, a method for drying by radiant heat from hot plates placed above and below the strip as described in Japanese Patent Laid Open No. 60-149871, and a method for drying by heat conduction upon contact of the web 14 and a roll which is heated by passing a heat medium inside the roll as described in Japanese Patent Laid Open No. 60-21334.

In all methods, to uniformly dry the strip-shaped coating solution coated on the web 14, heating is controlled by suitably changing the flow rate, the temperature or the manner of supply of hot air or heat medium depending on the kind and the coating amount of the web 14 and the photosensitive composition, the kind of solvent and the running speed. In addition, two or more of drying methods may be used in combination.

### [Take-up of Raw Continuous Sheet of Lithographic printing plate]

The resulting raw continuous sheet 14A of a lithographic printing plate is once taken up onto a take-up machine 28 in the form of a roll. By once taking up the raw continuous sheet 14A of the lithographic printing plate to the take-up machine 28, the coil time from the production of the long-sheet raw continuous sheet 14A to the sheet processing step for cutting the raw continuous sheet 14A to the size of the product can be long, and this method is thus more flexible than the method in which production through sheet processing is continuously conducted, and productivity can be improved.

### [Sheet Processing of Raw Continuous Sheet of Lithographic printing plate and Development]

In the sheet processing step, a protective sheet (slip sheet) is laminated on the overcoat layer and the roll is cut into the size of sheet products by a sawing machine and a cutter. In that case, an apparatus for adjusting the moisture content of slip sheet (not shown in the FIGURE) capable of adjusting temperature and humidity is preferably provided in order to adjust the moisture content of the slip sheet at 2 to 10% by weight, preferably 4 to 6.5% by weight. This is to prevent the moisture content of the overcoat layer from changing because of lamination of the slip sheet with the lithographic printing plate.

The photosensitive layer of the product of the lithographic printing plate processed into sheet is then subjected to imagewise exposure using, for example, a carbon arc lamp, a high-pressure mercury lamp, a xenon lamp, a metal halide lamp, a fluorescent lamp, a tungsten lamp, a halogen lamp, a helium-cadmium laser, an argon ion laser, a FD YAG laser, a helium-neon laser, a semiconductor laser (350 nm to 600 nm), and a solid laser and a semiconductor laser emitting infrared rays (760 nm to 1200 nm). After imagewise exposure with one of these known active rays, development treatment is conducted to form images on the surface of the aluminum plate support.

The lithographic printing plate is developed by the above-mentioned developer according to a conventional method by, for example, immersing the lithographic printing plate which has undergone exposure, and brushing it with a brush in the developer at a temperature of 0 to 60°C, preferably 15 to 40°C.

The photosensitive lithographic printing plate developed in this manner is further subjected to post-treatments using washing water, a rinsing solution containing a surfactant or a desensitizing solution containing gum Arabic or a starch derivative as described in Japanese Patent Laid Open Nos: 54-8002, 55-115045 and 59-58431.

The plate durability of the printing plate obtained by the treatments described above can be further improved by a post-exposure treatment according to the method described in Japanese Patent Laid Open No. 2000-89478 or a heating treatment such as burning. The lithographic printing plate obtained by these treatments is set up in an offset printing machine to be used for printing of large number of copies.

As described above, although the examples of the embodiments of the method for producing the lithographic printing plate according to the present invention have been described, the present invention is not limited to the examples of the embodiments, and various kinds of aspects can be adopted.

The present invention can be similarly applied to not only the method for producing the lithographic printing plate but also the application of the coating liquid containing particles which may be deformed and broken.

### [Examples]

The lithographic printing plate was produced by the method for producing the lithographic printing plate according to the present invention, and the adhesiveness and temporal stability or the like of the lithographic printing plate were evaluated. Hereinafter, producing conditions and evaluation results will be described.

### 1. Preparation of Original plate of Lithographic printing plate

### (1) Preparation of Web (Support)

In order to remove a rolling oil on the surface of an aluminum plate (material 1050) having a thickness of 0.3 mm, after degreasing processing was conducted at 50°C using 10% by mass of a sodium aluminate aqueous solution for 30 seconds, an aluminum surface was subjected to graining using three planting nylon brushes having a bristle diameter of 0.3 mm and a pumice-water suspension liquid (specific gravity: 1.1 g/cm³) having a median size of 25 µm, and was sufficiently washed with water. The plate was etched by immersing this plate in a sodium hydroxide aqueous solution of 25% by mass of 45°C for 9 seconds. After the plate was washed, the plate was washed by immersing the plate in a nitric acid of 20% by mass at 60°C for 20 seconds. The etching amount of the surface subjected to graining at this time was about 3 g/m².

Next, electrochemical roughening treating was continuously conducted using an alternating voltage of 60 Hz. The electrolytic solution at this time was an aqueous solution (containing 0.5% by mass of aluminum ions) containing 1% by mass of nitric acid and having a liquid temperature of 50°C. Referring to an alternating power supply waveform, electrochemical roughening treating was conducted using trapezoid rectangular alternating wave of which a time TP until a current value reaches a peak from zero is 0.8 msec and a duty ratio is 1:1 and using carbon electrodes as a counter electrode. Ferrite was used for an auxiliary anode. The peak value of a current density was 30 A/dm², 5% of the current flowing from the power supply was shunt to the auxiliary anode. Referring to the quantity of electricity in nitric acid electrolysis, the quantity of electricity when the aluminum plate was an anode was 175 C/dm².

Then, water washing by spraying was conducted.

Next, electrochemical roughening treatment was conducted in the same manner as in the nitric acid electrolysis under conditions where the quantity of electricity when the aluminum plate was on the anode was 50 C/dm² in an aqueous solution (containing 0.5% by mass of aluminum ions) containing 0.5 % by mass of hydrochloric acid and an electrolytic solution having a liquid temperature of 50°C. Then, water washing using a spray was conducted.

After a direct-current anodizing film of 2.5 g/m² was formed on this plate in a current density of 15 A/dm² by using 15% by mass of sulfuric acid (containing 0.5% by mass of aluminum ions) as the electrolytic solution, the plate was washed, dried, and then processed in an aqueous solution containing 2.5% by mass of silicic acid sodium at 30°C for 10 seconds. When the central line average coarseness (Ra) of this substrate was measured using a needle having a diameter of 2 µm, the central line average coarseness was 0.51 µm.

### (2) Formation of Image Recording Layer

After conducting the bar coating of the coating liquid for image recording layer having the following composition on the above-mentioned web, oven drying was conducted at 70°C for 60 seconds to form an image recording layer of a drying coating amount of 0.8 g/m². After an overcoat layer coating liquid (1) having the following composition was coated thereon using a wire bar so that the film thickness is set to 0.5 g/m², the overcoat layer coating liquid (1) was similarly dried at 70°C for 60 seconds to obtain an original plate 1 of a lithographic printing plate.

Coating liquid for image recording layer (1)
· water 100 g
· the following microcapsule (1) (solid content conversion) 5 g
· the following polymeric initiator (1) 0.5 g
· the following fluorinated surfactant (1) 0.2 g

### [Chemical Formula 1]

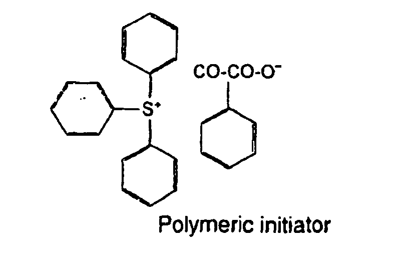

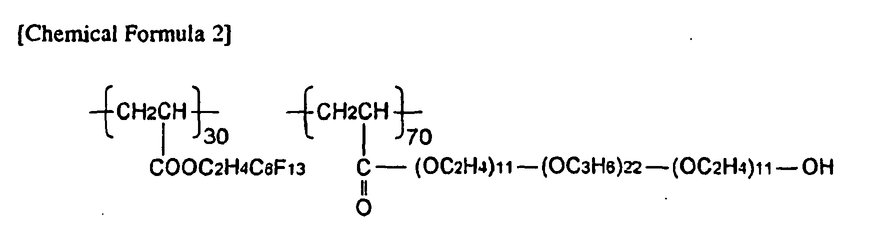

Fluorinated surfactant

### (Synthesis of Microcapsule (1))

Trimethylolpropane, a xylenediisocyanato adduct (produced by Mitsui Takeda Chemical Co., Ltd., TAKENATE D-110NTu) of 10 g, pentaerythritoltriacrylate (produced by Nippon Kayaku Co., Ltd., SR44Tu) of 3.15 g, the following infrared absorbent (1) of 0.35 g, 3-(N,N-diethylamino)-6-methyl-7-anilinofluoran (produced by Yamamoto Chemicals, ODBTu) of 1 g, and pyonin A-41CTu (produced by Takemoto Oil and fats) of 0.1 g as oil phase components were dissolved in 17 g of ethyl acetate.

40 g of an aqueous solution containing 4% by mass of PVA-205Tu as an aqueous phase component was prepared. The oil phase components and the aqueous phase component were mixed, and were emulsified for 10 minutes at 12000 rpm using a homogenizer. After the obtained emulsion was added to 25 g of distilled water and stirred for 30 minutes at room temperature, the emulsion was stirred at 40°C for 3 hours. The microcapsule liquid (1) thus obtained was diluted using distilled water so that the solid content concentration of a microcapsule liquid (1) was set to 20% by mass. The average particle diameter was 0.3 µm.

Overcoat layer coating liquid (1)
- The following mica dispersion (1) 8.0 g
- polyvinyl alcohol (saponification degree: 98.5 mol%) (produced by KURARAY CO. LTD., PVA110Tu) 1.3 g
- 2- ethylhexyl sodium sulfosuccinate 0.3 g
- water 133 g

### (Preparation of Mica Dispersion (1))

32 g of synthetic mica ("Somashifu ME-100Tu"; produced by CO-OP CHEMICAL CO., LTD., aspect ratio: 1000 or more) was added to 368 g of water, and the solution was dispersed by using the homogenizer until the average particle diameter (laser scattering method) was set to 0.5 µm to obtain a mica dispersion (1).

After conducting the bar coating of the coating liquid for image recording layer (2) having the following composition on the web (support), oven drying was conducted at 100°C for 60 seconds to form an image recording layer of a drying coating amount of 1.0 g/m². After an overcoat layer coating liquid (1) described above was coated thereon using a wire bar so that the film thickness is set to 0.5 g/m², the overcoat layer coating liquid (1) was similarly dried at 70°C for 60 seconds to obtain an original plate 2 of a lithographic printing plate.

Coating liquid for image recording layer (2)
- the following infrared absorbent (2) 0.05 g
- the above-described polymeric initiator (1) 0.2 g
- the following binder polymer (1) (average molecular weight: 80,000) 0.5 g
- polymerizable compound 1.0 g
   isocyanuric acid EO modified triacrylate
   (produced by SHIN-NAKAMURA CHEMICAL CO.,LTD., NK ester M-315Tu)
- naphthalene sulfonic acid salt of victoria pure blue 0.02 g
- the above-described fluorinated surfactant (1) 0.1g
- methyl ethyl ketone 18.0 g

A lithographic printing plate original plate 3 was completely similarly obtained except that the mica dispersion (1) was changed into the following mica dispersion (2).

### (Preparation of Mica Dispersion (2))

12 g of (trade name: suzurite 40HTu, produced by MRI) synthetic mica was added to 188 g of water to which 2 g of dodecyl sulfate soda was added, and the mixture was dispersed at 10,000 rpm for 30 minutes by using a homogenizer. Furthermore, 200 g of a gelatin aqueous solution of 5.6% by mass was added to obtain a mica dispersion (2).

A lithographic printing plate original plate 4 was obtained quite in the same way except that the mica dispersion (1) was changed to the following mica dispersion (3).

### (Preparation of Mica Dispersion (3))

13 parts of synthetic mica ("Somashifu MEB-3Tu", produced by CO-OP CHEMICAL CO., LTD.), 100 parts of an aluminum hydroxide dispersion (hygerite H42STu (produced by Showa Lightmetal Industries Co.Ltd., 1 part of sodium hexametaphosphate and 150 parts of water were mixed, and the mixture was dispersed to an average particle diameter of 0.7 µm in a wet dispersing machine such as a ball mill to obtain a mica dispersion (3).

### 2. Other Producing Conditions

The transferring speed of the web (support) was set to 100 m/min. Drying with a dryer was performed by a method for applying vertical perpendicular wind. A space between nozzle slits of this dryer is 2 mm; the pitch of the slit is 150 mm; and the wind velocity from the nozzle is 10 m/second.

The above-described coating liquid, the web and the dryer were used, and the coating method and the transferring method were changed and the mica dispersion (3) was produced.

### 3. Evaluation Methods

### (Evaluation of Adhesiveness)

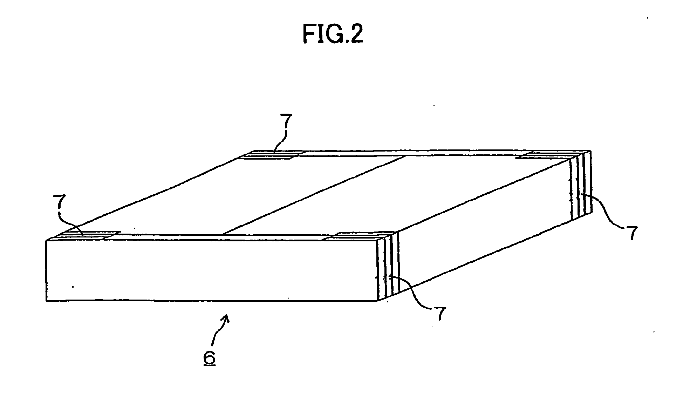

The obtained lithographic printing plates were laminated so that the image recording layer coating surface came into contact with the slip sheet to produce a laminate obtained by laminating lithographic printing original plates of 50 sheets. Referring to the used slip sheet, the basis weight, the thickness, the density and the smoothness degree were respectively 48 g/m², 60 µm, 0.08 g/cm³ and 310 seconds. As shown in Figure 2; after this laminate was packed by a kraft paper in which an aluminum foil was stuck on the inner surface, the laminate was fixed by sticking adhesive tapes 7, 7 ... to produce a packing object 6.

This packing object 6 was unpackaged after leaving the packing object 6 for one week in the environment of a temperature of 45°C and relative humidity of 75% supposing the case where a circulation and storage conditions are inferior, and the adhesiveness of the image recording layer coating surface and slip sheet was evaluated. When the lithographic printing plate and the slip sheet were able to be separated, the evaluation was defined as good. When the lithographic printing plate and the slip sheet were adhered and it is difficult to separate the lithographic printing plate and the slip sheet, the evaluation was defined as poor.

### (Evaluation of Temporal Stability)

Generally, in the case of a negative type image forming layer, an initiator or the like is decomposed as time goes by, and the reduced reactivity, i.e., low sensitivity is observed. After confirming that printed matters having no ink dirt adhered to a non-image part were obtained by printing the original plates of the lithographic printing plate of 100 sheets stored in the environment of a temperature of 45°C and relative humidity of 75% as described above, the printing of 500 sheets was continuously conducted. Thin line charts (charts obtained by exposing thin lines of 10, 12, 14, 16, 18, 20, 25, 30, 35, 40, 60, 80, 100 and 200 µm) of the printed matter of the final 600th sheet were observed using a 25 times magnifying glass, and thin line reproducibility was evaluated by a thin line width reproduced in ink without breaking.

The evaluation was conducted by the same method as that described by this thin line reproducibility to define as the evaluation of temporal stability. The original plate of the lithographic printing plate of which temporal stability is inferior can be distinguished by thin line reproducibility deteriorated by the storage in the temperature of 45°C and relative humidity of 75%.

### 4. Evaluation Results

### (Results of Evaluation by Coating Conditions)

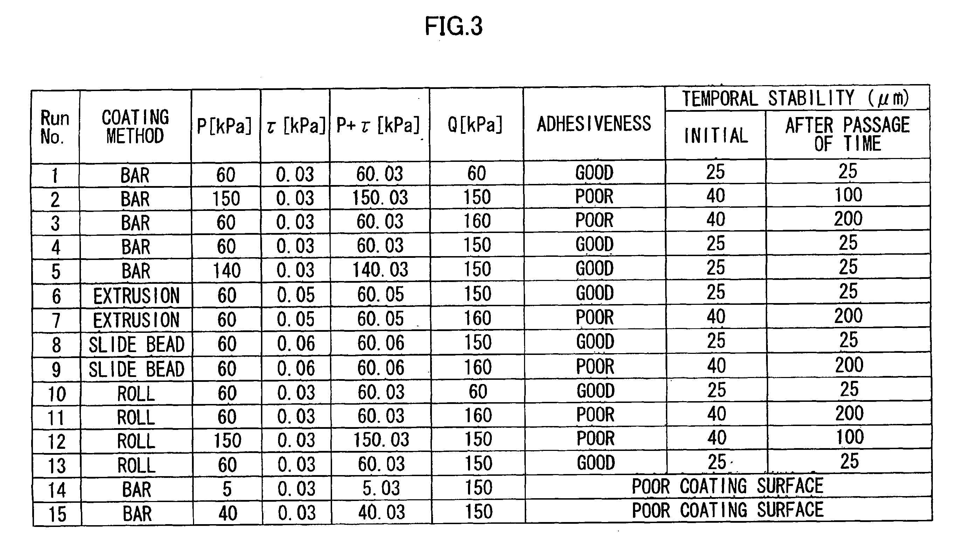

Figure 3 presents a table showing the evaluation results of samples in which the coating conditions were changed. Of these, sample Nos. 1 to 5 were prepared by bar coating; sample Nos. 6 and 7 by extrusion coating, sample Nos. 8 and 9 by slide bead coating, sample Nos. 10 to 13 by roll coating, and sample Nos. 14 and 15 by bar coating.

The table of Figure 3 confirmed that the adhesiveness and the temporal stability were good by setting the sum total value P+ τ of the pressure P applied to the coating liquid and shearing stress τ upon coating at 1.5 × 10⁵ Pa or less and by setting the contact pressure Q applied to the web upon transferring at 1.5 × 10⁵ Pa or less in spite of the coating methods (excluding the bar coating as exception).

### (Results of Evaluation by Storage Conditions)

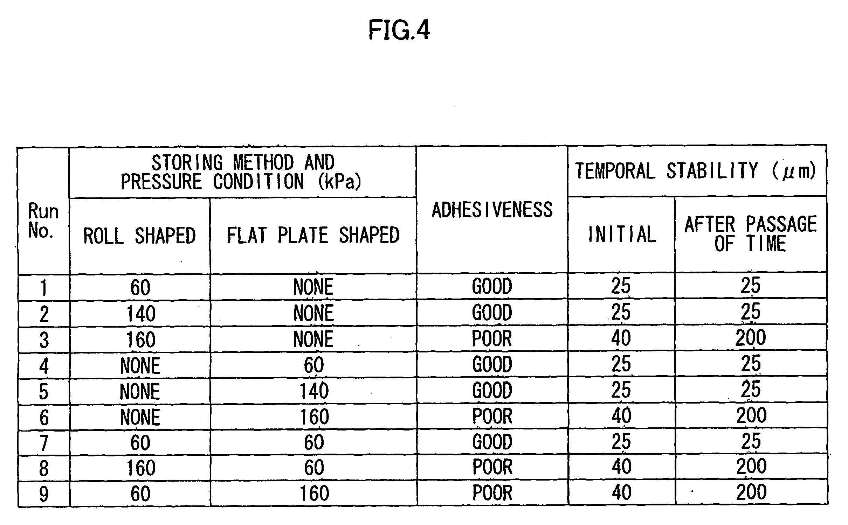

Figure 4 shows the evaluation results of samples in which storage conditions were changed. Of these, sample Nos. 1 to 3 were prepared by methods for taking-up the web in the form of a roll; samples Nos. 4 to 6 by methods for cutting the web and laminating the cut webs; and samples Nos. 7 to 9 by methods for cutting the web and laminating the cut web after take-up of the web in the form of a roll.

The table of Figure 4 confirmed that the adhesiveness and the temporal stability were good by setting the contact pressure Q applied to the web in take-up of the web in the form of a roll to 1.5 × 10⁵ Pa or less, or by setting the contact pressure Q added to the web in laminating at 1.5 × 10⁵ Pa or less.

### [Other Examples]

The web was coated, dried and transferred on the same conditions as Run No.1 of Table of Figure 3, and printing evaluations of ones obtained by take-up, storing, cutting and plate-storing on the conditions shown below were conducted (take-up direction is outer winding). The evaluation results are shown below.
(a) To set the pressure Q applied to the coating surface in take-up of the web in the form of a roll at 1.5 × 10⁵ Pa or less.
(b) To set the pressure (contact pressure) Q applied to the plate of the undermost layer at 1.5 × 10⁵ Pa or less when the webs are laminated and stored in a flat plate form. The printing evaluation was good by satisfying the both conditions.

## Claims

1. A method for producing a lithographic printing plate, **characterized by** comprising the step of
applying a coating layer liquid containing an inorganic compound as an overcoat on top of a photosensitive layer on a surface of a strip-shaped flexible web (14) at a pressure P applied to the coating liquid of more than 5 x 10⁴ Pa and 1.5 × 10⁵ Pa or less, said pressure P being a liquid pressure of the space(s) surrounded by a head of a coating section (24) and the web (14) and filled with the coating liquid, said inorganic compound comprising particles having a thin flat plate shape having a particle diameter along the average major axis of from 0.3 to 20 µm and an average thickness of 0.1 µm or less, wherein said coating is effected on a running web at a line speed of 60 m/min or more, and the coating liquid is applied in an amount of 25 ml/m² or less .

2. A method for producing a lithographic printing plate, **characterized by** comprising the step of
applying a coating layer liquid containing an inorganic compound as an overcoat on top of a photosensitive layer on a surface of a strip-shaped flexible web (14) at a shearing stress τ applied to the coating liquid of 1.5 × 10⁵ Pa or less, said shearing stress τ being the shearing stress applied to a liquid in a space surrounded by a head of a coating section (24) and the web (14) and filled with the coating liquid, said inorganic compound comprising particles having a thin flat plate shape having a particle diameter along the average major axis of from 0.3 to 20 µm and an average thickness of 0.1 µm or less, wherein said coating is effected on a running web at a line speed of 60 m/min or more, the coating liquid is applied in an amount of 25 ml/m² or less, and the pressure P applied to the coating liquid is more than 5 x 10⁴ Pa, said pressure P being a liquid pressure of the space(s) surrounded by a head of a coating section (24) and the web (14) and filled with the coating liquid.

3. A method for producing a lithographic printing plate, **characterized by** comprising the step of
applying a coating layer liquid containing an inorganic compound as an overcoat on top of a photosensitive layer on a surface of a strip-shaped flexible web (14) at a sum total value P + τ of a pressure P and a shearing stress τ applied to the coating liquid of 1.5 × 10⁵ Pa or less, said pressure P being a liquid pressure of the space(s) surrounded by a head of a coating section (24) and the web (14) and filled with the coating liquid, said shearing stress τ being the shearing stress applied to a liquid in a space surrounded by a head of a coating section (24) and the web (14) and filled with the coating liquid, said inorganic compound comprising particles having a thin flat plate shape having a particle diameter along the average major axis of from 0.3 to 20 µm and an average thickness of 0.1 µm or less, wherein said coating is effected on a running web at a line speed of 60 m/min or more, the coating liquid is applied in an amount of 25 ml/m² or less, and the pressure P applied to the coating liquid is more than 5 x 10⁴ Pa.

4. The method for producing a lithographic printing plate according to any one of claims 1 to 3, **characterized by** further comprising the steps of:
drying the coating layer; and
winding the strip-shaped flexible web (14) after drying the coating layer around a roller member at a contact pressure Q applied to the strip-shaped flexible web (14) of 1.5 × 10⁵ Pa or less and transferring the strip-shaped flexible web (14).

5. The method for producing the lithographic printing plate according to any one of claims 1 to 4, **characterized by** further comprising the steps of:
drying the coating layer; and
taking up the strip-shaped flexible web (14) after drying the coating layer in a form of a roll at a contact pressure Q applied to the strip-shaped flexible web (14) of 1.5 × 10⁵ Pa or less.

6. The method for producing the lithographic printing plate according to any one of claims 1 to 5, **characterized by** further comprising the steps of:
drying the coating layer; and
laminating a plurality of strip-shaped flexible webs (14) after drying the coating layer at a contact pressure Q applied to the strip-shaped flexible webs (14) of 1.5 × 10⁵ Pa or less.

## Patentansprüche

1. Verfahren zur Herstellung einer lithographischen Druckplatte, **dadurch gekennzeichnet, dass** das Verfahren den Schritt umfasst:
Aufbringen einer Beschichtungsflüssigkeit enthaltend eine anorganische Verbindung als einen Überzug auf einer photoempfindlichen Schicht auf einer Oberfläche einer streifenförmigen flexiblen Bahn (14) mit einem Druck P, welcher auf die Beschichtungsflüssigkeit ausgeübt wird, von mehr als 5 x 10⁴ Pa und 1,5 x 10⁵ Pa oder weniger, wobei der Druck P ein Flüssigkeitsdruck des Raums (der Räume) ist, welcher von einem Kopf eines Beschichtungsbereichs (24) und der Bahn (14) umgeben ist und mit der Beschichtungsflüssigkeit angefüllt ist, wobei die anorganische Verbindung Partikel mit einer Form von dünnen flachen Platten umfassen, mit einem Partikeldurchmesser entlang der mittleren Hauptachse von 0,3 bis 20 µm und einer mittleren Dicke von 0,1 µm oder weniger, wobei das Beschichten auf einer laufenden Bahn mit einer Geschwindigkeit von 60 m/min oder mehr durchgeführt wird, und wobei die Beschichtungsflüssigkeit mit einer Menge von 25 ml/m² oder weniger aufgebracht wird.

2. Verfahren zur Herstellung einer lithographischen Druckplatte, **dadurch gekennzeichnet, dass** das Verfahren den Schritt umfasst:
Aufbringen einer Beschichtungsflüssigkeit enthaltend eine anorganische Verbindung als einen Überzug auf eine photoempfindliche Schicht auf einer Oberfläche einer streifenförmigen flexiblen Bahn (14) mit einer Shear-Spannung τ, welcher auf die Beschichtungsflüssigkeit von 1,5 x 10⁵ Pa oder weniger angelegt wird, wobei die Shear-Spannung τ die Shear-Spannung ist, welche auf eine Flüssigkeit in einem Raum angelegt wird, welcher von einem Kopf eines Beschichtungsbereichs (24) und der Bahn (14) umgeben wird, und mit der Beschichtungsflüssigkeit angefüllt ist, wobei die anorganische Verbindung Partikel mit einer Form von dünnen flachen Platten umfassen, mit einem Partikeldurchmesser entlang der mittleren Hauptachse von 0,3 bis 20 µm und einer mittleren Dicke von 0,1 µm oder weniger, wobei das Beschichten auf einer laufenden Bahn mit einer Geschwindigkeit von 60 m/min oder mehr durchgeführt wird, die Beschichtungsflüssigkeit in einer Menge von 25 ml/m² oder weniger aufgebracht wird und der Druck, welcher an die Beschichtungsflüssigkeit angelegt wird, mehr als 5 x 10⁴ Pa beträgt, wobei der Druck P ein Flüssigkeitsdruck des Raumes (der Räume) ist, welcher von einem Kopf eines Beschichtungsbereichs (24) und der Bahn (14) umgeben ist und mit der Beschichtungsflüssigkeit angefüllt ist.

3. Verfahren zur Herstellung einer lithographischen Druckplatte, **dadurch gekennzeichnet, dass** das Verfahren den Schritt umfasst:
Aufbringen einer Beschichtungsflüssigkeit enthaltend eine anorganische Verbindung als einen Überzug auf einer photoempfindlichen Schicht auf einer Oberfläche einer streifenförmigen flexiblen Bahn (14), mit einem Gesamtwert P + τ eines Druckes P und einer Shear-Spannung τ, welche an die Beschichtungsflüssigkeit angelegt werden, von 1,5 x 10⁵ Pa oder weniger, wobei der Druck ein Flüssigkeitsdruck des Raumes (der Räume) ist, welcher von einem Kopf eines Beschichtungsbereichs (24) und der Bahn (14) umgeben wird und mit der Beschichtungsflüssigkeit angefüllt ist, wobei die Shear-Spannung τ die Shear-Spannung ist, angelegt auf eine Flüssigkeit in einem Raum, welcher von einem Kopf eines Beschichtungsbereichs (24) und der Bahn (14) umgeben wird, und mit der Beschichtungsflüssigkeit angefüllt ist, wobei die anorganische Verbindung Partikel umfasst, mit einer Form von dünnen flachen Platten, mit einem Partikeldurchmesser entlang der mittleren Hauptachse von 0,3 bis 20 µm und einer mittleren Dicke von 0,1 µm oder weniger, wobei die Beschichtung auf einer laufenden Bahn mit einer Geschwindigkeit von 60 m/min oder mehr durchgeführt wird, die Beschichtungsflüssigkeit in einer Menge von 25 ml/m² oder weniger aufgebracht wird und der Druck P, welcher an die Beschichtungsflüssigkeit angelegt wird, mehr als 5 x 10⁴ Pa beträgt.

4. Verfahren zur Herstellung einer lithographischen Druckplatte gemäß einem der Ansprüche 1 bis 3, **dadurch gekennzeichnet, dass** weiter die Schritte enthalten sind:
Trocknen der Beschichtung; und
Aufwickeln der streifenförmigen flexiblen Bahn (14) nach dem Trocknen der Beschichtung um ein Walzenelement mit einem Kontaktdruck Q, welcher an die streifenförmige flexible Bahn (14) angelegt wird, von 1,5 x 10⁵ Pa oder weniger und Befördern der streifenförmigen flexiblen Bahn (14).

5. Verfahren zur Herstellung einer lithographischen Druckplatte gemäß einem der Ansprüche 1 bis 4, **dadurch gekennzeichnet, dass** des Weiteren die Schritte umfasst sind:
Trocknen der Beschichtung; und
Aufnehmen der streifenförmigen flexiblen Bahn (14) nach dem Trocknen der Beschichtung in Form einer Rolle mit einem Kontaktdruck Q, welcher auf die streifenförmige flexible Bahn (14) ausgeübt wird, von 1,5 x 10⁵ Pa oder weniger.

6. Verfahren zur Herstellung der lithographischen Druckplatte gemäß einem der Ansprüche 1 bis 5, **dadurch gekennzeichnet, dass** des Weiteren die Schritte umfasst sind:
Trocknen der Beschichtung; und
Laminieren einer Vielzahl von streifenförmigen flexiblen Bahnen (14) nach dem Trocknen der Beschichtung mit einem Kontaktdruck Q, welcher an die streifenförmigen flexiblen Bahnen (14) angelegt wird, von 1,5 x 10⁵ Pa oder weniger.

## Revendications

1. Procédé de production d'un cliché lithographique, **caractérisé en ce qu'**il comprend l'étape consistant à :
appliquer un liquide de couche de revêtement contenant un composé inorganique en tant que revêtement supplémentaire sur une couche photosensible sur une surface d'une toile souple en forme de bande (14) à une pression P appliquée au liquide de revêtement supérieure à 5 x 10⁴ Pa et 1,5 x 10⁵ Pa ou moins, ladite pression P étant une pression de liquide du ou des espaces entourés par une tête d'une section d'enduction (24) et la toile (14) et remplis du liquide de revêtement, ledit composé inorganique comprenant des particules présentant la forme d'une mince plaque plate ayant un diamètre de particule le long de l'axe principal moyen de 0,3 à 20 µm et une épaisseur moyenne de 0,1 µm ou moins, dans lequel ladite enduction est effectuée sur une toile en déplacement à une vitesse linéaire de 60 m/mn ou plus, et le liquide de revêtement est appliqué en une quantité de 25 ml/m² ou moins.

2. Procédé de production d'un cliché lithographique, **caractérisé en ce qu'**il comprend l'étape consistant à :
appliquer un liquide de couche de revêtement contenant un composé inorganique en tant que revêtement supplémentaire sur une couche photosensible sur une surface d'une toile souple en forme de bande (14) à une contrainte de cisaillement τ appliquée au liquide de revêtement de 1,5 x 10⁵ Pa ou moins, ladite contrainte de cisaillement τ étant la contrainte de cisaillement appliquée à un liquide dans un espace entouré par une tête d'une section d'enduction (24) et la toile (14) et rempli du liquide de revêtement, ledit composé inorganique comprenant des particules présentant la forme d'une mince plaque plate ayant un diamètre de particule le long de l'axe principal moyen de 0,3 à 20 µm et une épaisseur moyenne de 0,1 µm ou moins, dans lequel ladite enduction est effectuée sur une toile en déplacement à une vitesse linéaire de 60 m/mn ou plus, le liquide de revêtement est appliqué en une quantité de 25 ml/m² ou moins, et la pression P appliquée au liquide de revêtement est supérieure à 5 x 10⁴ Pa, ladite pression P étant une pression de liquide du ou des espaces entourés par une tête d'une section d'enduction (24) et la toile (14) et remplis du liquide de revêtement.

3. Procédé de production d'un cliché lithographique, **caractérisé en ce qu'**il comprend l'étape consistant à :
appliquer un liquide de couche de revêtement contenant un composé inorganique en tant que revêtement supplémentaire sur une couche photosensible sur une surface d'une toile souple en forme de bande (14) à une valeur totale de somme P + τ d'une pression P et d'une contrainte de cisaillement τ appliquée au liquide de revêtement de 1,5 x 10⁵ Pa ou moins, ladite pression P étant une pression de liquide du ou des espaces entourés par une tête d'une section d'enduction (24) et la toile (14) et remplis du liquide de revêtement, ladite contrainte de cisaillement τ étant la contrainte de cisaillement appliquée à un liquide dans un espace entouré par
une tête d'une section d'enduction (24) et la toile (14) et rempli du liquide de revêtement, ledit composé inorganique comprenant des particules présentant la forme d'une mince plaque plate ayant un diamètre de particule le long de l'axe principal moyen de 0,3 à 20 µm et une épaisseur moyenne de 0,1 µm ou moins, dans lequel ledit revêtement est effectué sur une toile en déplacement à une vitesse linéaire de 60 m/mn ou plus, le liquide de revêtement est appliqué en une quantité de 25 ml/m² ou moins, et la pression P appliquée au liquide de revêtement est supérieure à 5 x 10⁴ Pa.

4. Procédé de production d'un cliché lithographique selon l'une quelconque des revendications 1 à 3, **caractérisé en ce qu'**il comprend en outre les étapes consistant à :
sécher la couche de revêtement ; et
enrouler la toile souple en forme de bande (14) après le séchage de la couche de revêtement autour d'un élément formant rouleau à une pression de contact Q appliquée à la toile souple en forme de bande (14) de 1,5 x 10⁵ Pa ou moins et transférer la toile souple en forme de bande (14).

5. Procédé de production du cliché lithographique selon l'une quelconque des revendications 1 à 4, **caractérisé en ce qu'**il comprend en outre les étapes consistant à :
sécher la couche de revêtement ; et
enrouler la toile souple en forme de bande (14) après le séchage de la couche de revêtement en la forme d'un cylindre à une pression de contact Q appliquée à la toile souple en forme de bande (14) de 1,5 x 10⁵ Pa ou moins.

6. Procédé de production du cliché lithographique selon l'une quelconque des revendications 1 à 5, **caractérisé en ce qu'**il comprend en outre les étapes consistant à
sécher la couche de revêtement ; et
lamifier une pluralité de toiles souples en forme de bande (14) après le séchage de la couche de revêtement à une pression de contact Q appliquée aux toiles souples en forme de bande (14) de 1,5 x 10⁵ Pa ou moins.
